# EUROPÄISCHE PATENTSCHRIFT

(11) **EP 2 744 105 B1**
(45) Veröffentlichungstag und Bekanntmachung des Hinweises auf die Patenterteilung: **30.09.2020**
(21) Anmeldenummer: 13188668.1
(22) Anmeldetag: 15.10.2013
(51) Int. Cl.: H03G 3/32, B60R 11/02

(54) **Einrichtung und Verfahren zur automatischen Anpassung der Lautstärke von Geräuschen in einem Fahrzeuginnenraum**
Device and method for the automatic adjustment of the sound volume in a vehicle interior
Dispositif et procédé d'adaptation automatique de l'intensité sonore de bruits dans l'habitacle d'un véhicule

(30) Priorität: 17.12.2012 DE 102012223314
(43) Veröffentlichungstag der Anmeldung: 18.06.2014
(73) Patentinhaber: Robert Bosch GmbH, 70442 Stuttgart (DE)
(72) Erfinder: Hoetzer, Dieter, 71706 Markgroeningen (DE); Krautter, Wolfgang, 71229 Leonberg (DE)

(56) Entgegenhaltungen:
- EP-A2- 1 739 546
- DE-A1- 10 052 104
- JP-A- S 644 145
- JP-A- 2005 191 668
- US-A1- 2009 160 229

## Beschreibung

Die Erfindung geht von einer Einrichtung und einem Verfahren nach der Gattung der unabhängigen Patentansprüche aus.

Aus EP 319 777 B1 und EP 623 995 B1 sind Einrichtungen und Verfahren zur automatischen, störgeräuschabhängigen Steuerung einer Wiedergabelautstärke einer Audioeinrichtung bekannt. Ziel ist es hierbei jeweils, ein Störgeräusch in einem Fahrzeuginnenraum, welches eine Audiowidergabe zu übertönen droht, zu erfassen und die Wiedergabelautstärke entsprechend dem erfassten Störgeräuschpegel zu steuern, so dass eine ausreichende Verständlichkeit der Audiowiedergabe sichergestellt werden kann.

DE 44 105 32 B4 offenbart eine Reduzierung einer Radio- oder CD- Wiedergabelautstärke in dem Fall, dass gleichzeitig eine Sprach-Anweisung eines FahrzeugNavigationssystems ausgegeben wird.

JP 2011 015 018 A und DE 198 27 197 A1 offenbaren die Erkennung von Sprache im Fahrzeug und die Reduzierung einer Radio-Wiedergabelautstärke bei erkannter Sprache.

Aus JP 2005 191 668 ist eine Vorrichtung zur Erzeugung von Klang bekannt, welche das Klangbild eines Lautsprechers an einem Referenzpunkt verändert, wenn ein Dialogpositionssignal erkannt wird.

US 2009/0160229 A1 offenbart eine Kraftfahrzeugsitzvorrichtung umfassend eine Vorrichtung zum Schwenken eines Sitzes, mittels welcher die Position des Sitzes in Abhängigkeit des Zustands geändert wird, in welchem sich ein Passagier befindet.

### Vorteile der Erfindung

Die Erfindung, die durch die unabhängigen Patentansprüche definiert ist, hat demgegenüber den Vorteil, dass die Absicht eines Fahrzeuginsassen, ein Gespräch zu führen, frühzeitig erkannt und die Lautstärke von auf den Fahrzeuginnenraum einwirkenden Geräuschquellen schon vor Aufnahme des Gesprächs reduziert wird. Damit wird der Fahrzeuginsasse von einer manuellen Einstellung der Geräuschquelle oder Geräuschquellen entlastet. Dies ist insbesondere für den Fahrzeugführer, der mit der Fahraufgabe beschäftigt ist und dieser seine volle Aufmerksamkeit widmen soll, von Bedeutung, stellt aber auch für andere Fahrzeuginsassen eine Erleichterung dar. Eine besondere Erleichterung wird insbesondere dann erreicht, wenn mehrere Geräuschquellen vorhanden und aktiv sind, wie beispielsweise ein Autoradio, daneben eine Lüftung oder Fahrzeug-Klimatisierung, ein Fahrzeugnavigationssystem, welches akustische Fahrrichtungshinweise ausgibt, ein Mobiltelefon, welches durch akustische Signalisierung den Eingang eines Telefonats anzeigt, eine Freisprecheinrichtung, die akustische Signale eines Telefonats wiedergibt und/oder dergleichen mehr. Eine Geräuschminimierung kann dabei in einer Reduzierung der Wiedergabelautstärke im Fall von beispielsweise Autoradio, Fahrzeugnavigationssystem, Mobiltelefon oder Freisprecheeinrichtung, in einer Reduzierung einer Lüfterdrehzahl im Fall der Lüftung oder Klimatisierung oder auch in einer vollständigen Abschaltung der Geräusche erzeugenden Einrichtung oder Einrichtungen bestehen.

Das Vorliegen oder das Bevorstehen einer Gesprächssituation, welche eine Reduzierung der Geräusche im Fahrzeuginnenraum erfordert oder wünschenswert erscheinen lässt, wird dabei erfindungsgemäß auf Grundlage von Bewegungs- und/oder Ortspositionsinformationen des Fahrzeugs erkannt.

In einer vorteilhaften Ausprägung der Erfindung wird bei einer Reduzierung einer Fahrgeschwindigkeit des Fahrzeugs und einer gleichzeitigen Annäherung des Fahrzeugs an einen Fahrbahnrand auf das Vorliegen oder Bevorstehen einer Gesprächssituation erkannt. Dieses Fahrverhalten kann beispielsweise typischerweise beobachtet werden, wenn ein Fahrzeuginsasse einen Passanten nach dem Weg zu einem bestimmten Ziel oder zu anderen Informationen befragen möchte. Dieses Fahrverhalten kann typischerweise auch beispielsweise im Rahmen einer Verkehrs- und/oder Fahrzeugkontrolle durch die Polizei beobachtet werden, wobei üblicherweise eine verbale Kommunikation zwischen Polizeibeamten und Fahrzeugführer erfolgt. Dieses Verhalten kann beispielsweise auch dann beobachtet werden, wenn ein Fahrzeugführer einem nahenden Einsatzfahrzeug mit Einsatzsignal den Weg frei geben möchte. In letzterem Fall erfolgt zwar in der Regel keine verbale Kommunikation mit Außenstehenden, dennoch kann die Reduzierung der Innenraumgeräusche gewünscht sein, um die Wahrnehmung des oder weiterer Einsatzsignale zu erleichtern.

Die Fahrgeschwindigkeit oder Fahrzeuggeschwindigkeit kann aus den Signalen eines Geschwindigkeitsanzeigers, auch als "Tachometer" oder kurz "Tacho" des Fahrzeugs bezeichnet, entsprechenden Informationen auf einem Datenbus des Fahrzeugs oder beispielsweise auch aus Informationen eines Satellitenortungsempfängers gewonnen werden. Die Information über die Annäherung an einen Fahrbahnrand kann beispielsweise durch eine hochpräzise Eigenortung der Fahrzeugposition und Abgleich mit entsprechend detailgenauen Kartendaten oder durch beispielsweise die Sensorik und Signalverarbeitung eines sogenannten Spurhalteassistenten, auch Spurverlassenswarner oder Lane Departure Warning System genannt, bereitgestellt werden. Ein Spurverlassenswarner erfasst mittels einer in die Umgebung des Fahrzeugs gerichteten Kamera ein Umgebungsbild des Fahrzeugs und bestimmt daraus, beispielsweise durch Erkennung einer Fahrbahnmarkierung im Kamerabild und durch Vermessung des Abstandes des Fahrzeugs zur Fahrbahnmarkierung den Abstand zum Fahrzeugrand. Anderweitige Mittel zur Bestimmung des Abstandes des Fahrzeugs zum Fahrbahnrand sind ebenfalls möglich.

Daneben ist es auch möglich, allein auf Grundlage einer Fahrzeuggeschwindigkeit auf eine mögliche Gesprächssituation zu schließen. Es kann beispielsweise auf eine Gesprächssituation geschlossen werden, wenn das Fahrzeug zum Stillstand gekommen ist oder wenn das Fahrzeug zum Stillstand gekommen ist und bereits für eine bestimmte Zeit, etwa im Bereich weniger Minuten steht. Diese Situation könnte vorliegen, wenn ein Fahrzeugführer ein Telefongespräch führen oder Einstellungen an einem Fahrerinformations-, beispielsweise Fahrzeugnavigationssystem per Spracheingabe, vornehmen möchte.

In einer weiteren vorteilhaften Ausprägung der Erfindung wird bei Annäherung der Fahrzeugposition an eine Infrastruktureinrichtung, an der eine akustische, insbesondere verbale, Kommunikation zwischen Infrastruktureinrichtung oder Personal der Infrastruktureinrichtung einerseits sowie dem Fahrzeugführer oder einem Fahrzeuginsassen andererseits erfolgt, auf das Vorliegen oder Bevorstehen einer Gesprächssituation erkannt. Eine solche Infrastruktureinrichtung kann eine Mautstelle an einer Autobahn sein, an der üblicherweise eine Mautgebühr zu entrichten ist, die vielfach von Personen entgegengenommen wird. Eine solche Infrastruktureinrichtung kann beispielsweise ein Schnellrestaurant mit sogenanntem "Drive-In-Schalter" sein, an dem eine Bestellung verbal einem Restaurant-Mitarbeiter aufgegeben wird. Eine solche Infratruktureinrichtung kann ein Werkstor oder eine Werkseinfahrt an einem Werks- oder Firmengelände sein, an dem eine Kommunikation mit einem Werksschutz-Mitarbeiter erforderlich sein kann. Diese Aufzählung ist beispielhaft und nicht abschließend.

Die Annäherung der Fahrzeugposition an eine solche Infrastruktureinrichtung kann vorteilhaft durch Abgleich einer Ortsposition oder eine Abfolge von Ortspositionen des Fahrzeugs mit einer Karte bestimmt werden, in welcher Karte die geographische Lage der relevanten Infratruktureinrichtungen, gemäß vorherigen Beispielen also Mautstellen, Schnellrestaurants und Werkseinfahrten, vermerkt ist. Die Einrichtung zur Bestimmung einer jeweiligen Ortsposition des Fahrzeugs kann als Bestandteil eines Fahrzeugnavigationssystems vorliegen, welches aus empfangenen Signalen von Satelliten eines Satellitenortungssystems, wie GPS, eine Ortsposition feststellt. Die aus den Satellitensignalen bestimmte Ortsposition kann zur Erhöhung der Genauigkeit der Positionsbestimmung mit einer Straßenkarte abgeglichen werden, welche ebenfalls als Bestandteil eines Navigationssystems vorliegt. Die Annäherung der Fahrzeugposition an eine Infrastruktureinrichtung kann insbesondere vorteilhaft durch Beobachtung einer Folge von Fahrzeugpositionen festgestellt werden, wenn diese auf einem zu einer Infrastruktureinrichtung hin führenden Verkehrsweg liegen.

Erfindungsgemäß werden zur Verfeinerung oder Plausibilisierung der Erkennung des Vorliegens oder Bevorstehens einer Gesprächssituation Aktivitäten eines Fahrzeuginsassen erfasst und ausgewertet. So kann in den zuvor beschriebenen Fällen, nämlich nach Halt des Fahrzeugs, bei Annäherung an eine Infrastruktureinrichtung oder bei Annäherung den Fahrbahnrand und Verringerung der Fahrzeuggeschwindigkeit, die Betätigung eines Fensterhebers zum Öffnen eines Fahrzeugfensters durch einen Fahrzeuginsassen, sei es der Fahrzeugführer oder ein Mitinsasse, als Bestätigung über das Vorliegen oder Bevorstehen einer Gesprächssituation bewertet werden. Es wird dabei davon ausgegangen, dass das Öffnen des Fensters in diesen Situationen dazu dient, eine verbale Kommunikation mit einer Person außerhalb des Fahrzeugs zu ermöglichen. Ferner kann in diesen beschriebenen Fällen eine Blick- oder Kopfausrichtung in Richtung Fahrzeug-Seitenfenster, vorzugsweise in Verbindung mit erfolgter oder erfolgender Öffnung des Seitenfensters, als Bestätigung über das Vorliegen oder Bevorstehen einer Gesprächssituation bewertet wird. Eine Blick- oder Kopfausrichtungs-Erkennung kann dabei beispielsweise mit einer in den Innenraum des Fahrzeugs gerichteten Kamera und eine dazugehörige Signalverarbeitung, wie sie beispielsweise zur Überwachung von Fahrzeugführern im Zusammenhang mit einer Müdigkeits-Erkennung zum Einsatz kommen, erfasst werden.

In weiterer Ausgestaltung kann das erfindungsgemäße Verfahren auch als sogenanntes lernendes oder selbst adaptierendes Verfahren ausgestaltet sein. Hierbei werden Verhaltensmuster eines Fahrzeuginsassen, insbesondere des Fahrzeugführers erfasst und aus einem aktuellen Verhalten und einer Historie von Verhaltensmustern auf das Vorliegen einer Gesprächssituation geschlossen. So kann beispielsweise an solche Ortspositionen, an denen der Fahrzeugführer regelmäßig die Wiedergabelautstärke des Autoradios manuell reduziert, auf das Vorliegen einer Gesprächssituation geschlossen werden. In der Folge können bei Annäherung der Fahrzeugposition an diesen Ort die oder weitere Geräusche im Fahrzeuginnenraum erzeugende Einrichtung oder Einrichtungen zur Reduzierung der Geräusche automatisch gesteuert werden, insbesondere die Wiedergabelautstärke des Autoradios automatisch reduziert werden.

### Zeichnungen

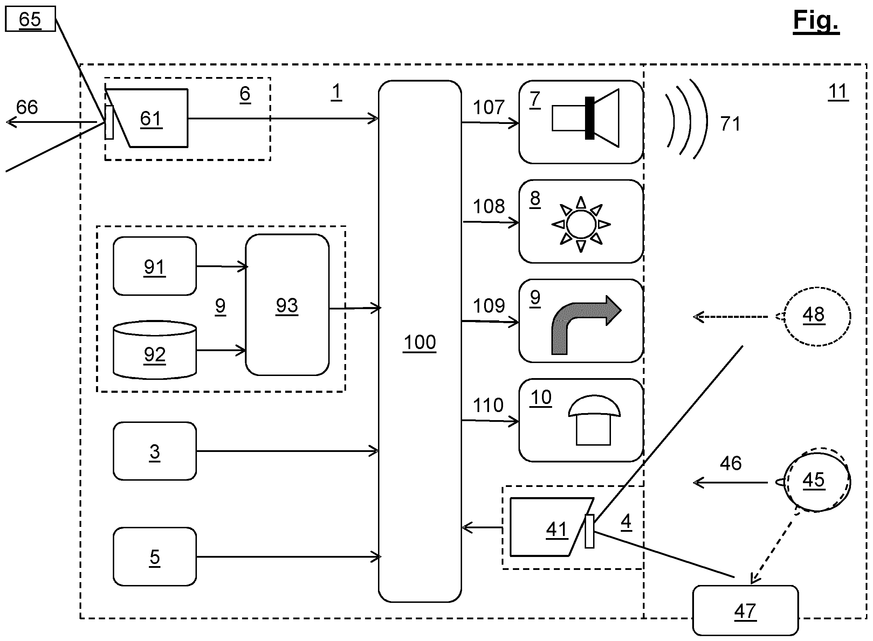

Ausführungsbeispiele der Erfindung sind in der Figur dargestellt und werden nachstehend näher erläutert.

Die Figur zeigt ein Blockschalt- und Funktionsbild einer Steuereinrichtung zur Durchführung des erfindungsgemäßen Verfahrens.

### Beschreibung der Ausführungsbeispiele

In der Figur ist ein Fahrzeug, in dem die erfindungsgemäße Steuereinrichtung 100 zur bedarfsabhängigen Geräuschverminderung angeordnet ist und betrieben wird, mit dem Bezugszeichen 1 bezeichnet.

Bei dem hier beschriebenen Ausführungsbeispiel sind in dem Fahrzeug mehrere, Geräusche oder Audiosignale erzeugende und abgebende Einrichtungen vorhanden. Dabei handelt es sich vorliegend um ein Autoradio 7, welches Rundfunksignale empfängt und die darin enthaltenen Programminformationen, also Unterhaltungsprogramm- oder Informationsprogramm-Informationen als akustische Signale 71 über einen Lautsprecher in eine Fahrgastzelle bzw. einen Fahrzeuginnenraum 11 ausgibt. Bei den Programminformationen kann es sich um Musikstücke, Nachrichten, Verkehrsdurchsagen oder ähnliches handeln. Ferner kann das Autoradio 7 auch über einen Medienspieler zum Abspielen von auf einem Speichermedium wie CD, DVD oder Speicherkarte gespeicherten Signalen, beispielsweise Musikstücke umfassen, die ebenfalls als akustische Signale 71 über Lautsprecher 71 in den Fahrzeuginnenraum 11 ausgegeben werden.

Als weitere Audiosignalquelle oder allgemeiner Geräuschquelle ist eine Fahrzeugklimatisierung 8, dabei insbesondere ein Gebläse, welches entweder unmittelbar oder mittelbar über den erzeugten Luftstrom und Ausströmgeräusche an Luftdüsen Geräusche im Innenraum 11 des Fahrzeugs 1 erzeugt, vorgesehen. Daneben kann beispielsweise ein Fahrzeugnavigationssystem 9 vorhanden sein, das abhängig von einem aktuellen Fahrzeugstandort und einer berechneten Fahrroute von einem Startzu einem Zielort akustische Zielführungsinformationen, wie "An der nächsten Kreuzung rechts abbiegen" oder dergleichen über einen Lautsprecher in den Fahrzeuginnenraum 11 ausgibt. Beispielsweise kann als eine weitere Geräuschquelle ein Mobiltelefon 10 mit Freisprecheinrichtung vorhanden sein, wobei die Klingelsignale oder Sprachsignale eines mit diesem Mobiltelefon 10 verbundenen Gesprächs-Teilnehmers über den lautgeschalteten Lautsprecher des Mobiltelefons 10 oder über den Lautsprecher der Freisprecheinrichtung, mit der das Mobiltelefon verbunden ist, in den Fahrzeuginnenraum 11 ausgegeben werden.

Die Steuereinrichtung ist erfindungsgemäß dazu ausgebildet, im Falle einer Gesprächssituation im Fahrzeuginnenraum 11 den Pegel der genannten Geräuschquellen 7, 8, 9, 10 zumindest zu reduzieren. Es kann daneben auch vorgesehen sein, die Geräusche der oder einzelner der Geräuschquellen 7, 8, 9, 10 vollständig zu unterbinden durch Abschalten oder Stummschalten der jeweiligen Einrichtung 7, 8, 9, 10. Dazu erzeugt die Steuereinrichtung 100 Steuersignale 107, 108, 109 und 110 zur Ansteuerung angeschlossenen Einrichtungen 7, 8, 9 und 10.

Eine Gesprächssituation, insbesondere eine bevorstehenden Gesprächssituation, also die Intention eines Fahrzeugführers 45 oder eines weiteren Fahrzeuginsassen 48 werden auf Grundlage von Informationen über eine Bewegung und/oder eine Ortsposition des Fahrzeugs 1 erkannt. Dazu greift die Steuereinrichtung 100 auf eine Sensorik zu, welche diese Informationen bereitstellt.

Eine Information über eine Bewegung oder einen Bewegungszustand des Fahrzeugs wird beispielsweise von einem Radsensor des Fahrzeugs zur Verfügung gestellt, aus welcher Information ein Signal für eine Geschwindigkeitsanzeige abgeleitet wird. Eine Information über den Bewegungszustand kann dabei unmittelbar aus dem Radsensor-Signal oder aus dem daraus abgeleiteten Geschwindigkeitssignal hergeleitet werden. Im vorliegenden Fall wird das Geschwindigkeitssignal 3, welches auf einem Datenbus des Fahrzeugs 1 zur Verfügung steht, genutzt, um eine Information über die Fahrzeuggeschwindigkeit zu erhalten. In einer einfachsten Ausführungsform der Erfindung wird bei Stillstand des Fahrzeugs, welcher anhand des Geschwindigkeitssignals 3 feststell bar ist, eine potenzielle Gesprächssituation im Fahrzeuginnenraum angenommen und zur Reduzierung der Lautstärke der Geräuschquellen 7, 8, 9 und/oder 10 entsprechende Steuersignale 107, 108, 109 und/oder 110 von der Steuereinrichtung 100 erzeugt und an die Geräuschquellen 7, 8, 9 und/oder 10 ausgegeben.

Weiterhin greift die Steuereinrichtung 100 in vorteilhafter Ausführung der Erfindung auch auf Positionssignale des Navigationssystems 9 zu. Das Navigationssystem 9 umfasst zur Bereitstellung der Positionssignale in an sich bekannter Weise Ortungsmittel 91, etwa einen Empfänger für Satellitenortungssignale, wie GPS, an dessen Ausgang Ortskoordinaten der aktuellen Ortsposition des Satellitenempfängers 91 anstehen. Ferner weist das Navigationssystem 9 eine digitale Karte, im Falle eines Fahrzeugnavigationssystems insbesondere eine Straßenkarte 92 auf. Durch Abgleich der mittels Satellitenortung 91 bestimmten Position mit der Straßenkarte kann in an sich bekannter Weise die Ortungsgenauigkeit erhöht werden und eine Straßen- oder auch fahrspurgenaue Positionsbestimmung erfolgen. Weiter können vorzugsweise in der Straßenkarte auch die Ortpositionen von Infrastruktureinrichtungen, wie Mautstellen, Einfahrten zu Werksgeländen oder andere vermerkt sein. Damit kann durch Vergleich einer Abfolge von Ortsposition und/oder durch Feststellung einer aktuell befahrenen Straßen eine Annäherung an eine solche Infrastruktureinrichtung festgestellt werden.

Zur Bestimmung der Ortsposition können ferner auch Signale einer Bilderkennungseinrichtung 6, umfassend eine Kamera 61 und eine zugeordnete, nicht separat dargestellte Bildauswertung, herangezogen werden. Die Kamera 61 ist dabei in Fahrtrichtung 66 des Fahrzeugs 1 ausgerichtet und erfasst die vor dem Fahrzeug liegende Fahrbahn sowie eine Fahrbahn-Randmarkierung 65. Auf Grundlage der erfassten Bilder kann die Bilderkennungseinrichtung etwa eine Annäherung des Fahrzeugs an den Fahrbahnrand feststellen. Es ist darüber hinaus auch möglich, in dem Kamerabild bestimmte Verkehrszeichen, wie etwa eine "Haltekelle" eines am Straßenrand stehenden Polizeibeamten zu erkennen.

Eine Gesprächssituation, insbesondere das Bevorstehen einer Gesprächssituation, oder anders ausgedrückt die Intention des Fahrzeugführers 45 oder eines weiteren Fahrzeuginsassen, wie eines Beifahrers 48 zur Führung eines Gesprächs kann daraus abgeleitet werden, dass eine Annäherung der Ortsposition des Fahrzeugs 1 an eine der genannten Infrastruktureinrichtungen erfolgt. So wird die Notwendigkeit einer verbalen Kommunikation zwischen Fahrzeugführer 45 und einem Bediensteten an einer Mautstelle angenommen, ebenso etwa die Notwendigkeit einer Kommunikation zwischen Fahrzeugführer 45 oder Fahrzeuginsassen 48 und einem Werksschutzbediensteten an einer Werkseinfahrt. Weiterhin kann auf die Intention eines Gesprächs mit einem Fahrzeugexternen angenommen werden, wenn sich die Fahrzeugposition einem Fahrzeugrand 65 annähert, was alleine mittels hochgenauer Ortung 93 oder Bilderkennung 6 oder eine Kombination beider Systeme feststellbar ist, und die Geschwindigkeit des Fahrzeugs verringert wird. Hier kann etwa eine Verkehrskontrolle durch die Polizei und eine intendierte Kommunikation mit einem Polizeibeamten angenommen werden oder die Absicht, einen Passanten nach dem Weg oder einer anderen Information zu fragen.

Ein Verfeinerung oder Plausiblisierung der Erkennung einer Gesprächssituation mittels Ortspositions- und/oder Fahrzeug-Bewegungserkennung erfolgt durch Beobachtung der Fahrzeuginsassen, also des Fahrzeugführers 45 und/oder weiterer Fahrzeuginsassen 48.

Dazu ist eine Innenraum-Überwachungskamera 41 mit zugeordneter Bilderkennung, also kurz eine Innenraum-Videoüberwachung 4 vorgesehen. Die Kamera 41 ist dabei vorteilhaft im Bereich des Rückspiegels im oberen Bereich der Windschutzscheibe angeordnet und erfasst den gesamten Fahrzeuginnenraum 11, soweit dieser nicht durch Hindernisse verdeckt ist. Im Zusammenhang mit der vorliegenden Erfindung ist die Innenraum-Videoüberwachung dazu ausgebildet, eine Kopfausrichtung und/oder Blickrichtung 46 des Fahrzeugführers 45 oder weiterer Fahrzeuginsassen zu erfassen. Darüber hinaus werden auch etwa die Positionen der Hände des Fahrzeugführers oder weiterer Fahrzeuginsassen 48 festgestellt.

Schließlich kann die Beobachtung der Fahrzeuginsassen auch die Beobachtung bestimmter Bedienelemente, wie im vorliegenden Fall der Bedienelemente 5 zur Betätigung der Fensterheber des Fahrzeugs 1 umfassen.

Wird in den oben genannten Situationen, also insbesondere bei Annäherung der Fahrzeugposition an eine Infrastruktureinrichtung oder den Fahrbahnrand und/oder bei Verminderung der Fahrzeuggeschwindigkeit zusätzlich festgestellt, dass der Fahrzeugführer 45 oder ein Fahrzeuginsassen seinen Blick 46 in Richtung Fahrzeug-Seitenfenster 47 richtet oder seinen Kopf Richtung Fahrzeug-Seitenfenster 47 dreht und/oder dass der Fahrzeugführer 45 ein weiterer Fahrzeuginsasse des Fensterheber betätigen möchte oder dies tatsächlich tut, so wird auf das Vorliegen einer Gesprächsabsicht mit einem Fahrzeugexternen geschlossen und in der Folge die eine oder mehreren Geräusche 71 erzeugenden Einrichtungen 7, 8, 9 und/oder 10 zur Verringerung ihrer Geräusche angesteuert. Die Reduktion der Lautstärke beispielsweise des Autoradios 7 wird an das Öffnen des Seitenfensters 47 gekoppelt. Dabei kann das Radio 7 bei einer bestimmten Fensterstellung leise geschaltet werden oder aber die Lautstärke kontinuierlich synchron zur Fensterstellung reduziert werden.

Bei den oben beschriebenen Situationen handelt es sich um Beispiele, die den Gegenstand der vorliegenden Erfindung nicht beschränken sollen. Vielmehr sind auch weitere Situationen, in denen eine Gesprächsintention angenommen werden kann, vorstellbar und mit den beschriebenen Mitteln erkennbar. Diese werden von der vorliegenden Erfindung umfasst ebenso auch, wie etwa eine anderweitige Kombination der beschriebenen Sensorik zur Erkennung einer Gesprächsintention. Der Umfang der Erfindung ist durch die Ansprüche definiert.

## Patentansprüche

1. Verfahren zur automatischen Steuerung einer Einrichtung (7, 8, 9, 10), nämlich einer Lüftung oder Fahrzeug-Klimatisierung, welche Geräusche (71) im Innenraum (11) eines Fahrzeugs (1) erzeugt, wobei die Einrichtung (7, 8, 9, 10) zur Reduzierung der von ihr erzeugten Geräusche (71) im Fahrzeuginnenraum (11) in Abhängigkeit von der Erkennung einer Gesprächssituation im Fahrzeuginnenraum (11) gesteuert wird,
wobei das Vorliegen oder Bevorstehen einer Gesprächssituation auf Grundlage von einer Bewegungs- und/oder Ortspositions-Information des Fahrzeugs (1) erkannt wird, **dadurch gekennzeichnet,**
**dass** zur Erkennung des Vorliegens oder Bevorstehens einer Gesprächssituation zusätzlich Aktivitäten eines Fahrzeuginsassen (45, 48) erfasst und ausgewertet werden, wobei die Positionen der Hände des Fahrzeugführers (45) oder weiterer Fahrzeuginsassen (48) mittels einer Innenraum-Videoüberwachung (4) festgestellt bzw. erfasst werden.

2. Verfahren nach Anspruch 1, **dadurch gekennzeichnet, dass** bei Reduzierung einer Fahrzeuggeschwindigkeit und Annäherung einer Fahrzeugposition an einen Fahrbahnrand auf das Vorliegen oder Bevorstehen einer Gesprächssituation erkannt wird.

3. Verfahren nach einem der vorhergehenden Ansprüche, **dadurch gekennzeichnet, dass** bei Annäherung einer Fahrzeugposition an eine Infrastruktureinrichtung, an der eine akustische, insbesondere verbale, Kommunikation zwischen Infrastruktureinrichtung oder Personal der Infrastruktureinrichtung einerseits sowie dem Fahrzeugführer oder einem Fahrzeuginsassen andererseits erfolgt, auf das Vorliegen oder Bevorstehen einer Gesprächssituation erkannt wird.

4. Verfahren nach Anspruch 3, **dadurch gekennzeichnet, dass** die Betätigung eines Fensterhebers zum Öffnen eines Fahrzeugfensters (47) als Bestätigung über das Vorliegen oder Bevorstehen einer Gesprächssituation bewertet wird.

5. Verfahren nach einem der Ansprüche 3 oder 4, **dadurch gekennzeichnet, dass** eine Blick- oder Kopfausrichtung (46) eines Fahrzeuginsassen (45) erfasst wird und eine Blick- oder Kopfausrichtung in Richtung Fahrzeug-Seitenfenster (47) als Bestätigung über das Vorliegen oder Bevorstehen einer Gesprächssituation bewertet wird.

6. Steuereinrichtung (100) zur automatischen Steuerung einer Einrichtung (7, 8, 9, 10), nämlich einer Lüftung oder Fahrzeug-Klimatisierung, welche Geräusche (71) im Innenraum (11) eines Fahrzeugs (1) erzeugt, mit Erkennungsmitteln (100) zur Erkennung einer Gesprächssituation im Fahrzeuginnenraum (11), ausgebildet zur Erzeugung eines Steuersignals (107, 108, 109, 110) zur Ansteuerung der Einrichtung (7, 8, 9, 10) zur Reduzierung der von ihr erzeugten Geräusche (71) im Fahrzeuginnenraum (11) in Abhängigkeit von der Erkennung einer Gesprächssituation im Fahrzeuginnenraum (11) mittels der Erkennungsmittel (100),
wobei die Erkennungsmittel (100) zur Erkennung auf das Vorliegen oder Bevorstehen einer Gesprächssituation auf Grundlage von einer Bewegungs- und/oder Ortspositions-Information des Fahrzeugs (1) ausgebildet sind,
**gekennzeichnet durch**
eine Ausbildung einer Innenraum-Videoüberwachung (4) zur Erkennung auf das Vorliegen oder Bevorstehen einer Gesprächssituation auf Grundlage von Aktivitäten eines Fahrzeuginsassen (45, 48), wobei die Positionen der Hände des Fahrzeugführers (45) oder weiterer Fahrzeuginsassen (48) festgestellt bzw. erfasst werden.

7. Steuereinrichtung nach Anspruch 6, weitergebildet zur Durchführung des Verfahrens nach mindestens einem der Ansprüche 2 bis 5.

## Claims

1. Method for automatically controlling a device (7, 8, 9, 10), specifically a ventilation device or vehicle air-conditioning device, which generates noise (71) in the passenger compartment (11) of a vehicle (1), wherein in order to reduce the noise (71) generated by the device (7, 8, 9, 10), in the passenger compartment (11), said device (7, 8, 9, 10) is controlled in accordance with the detection of a conversation situation in the vehicle passenger compartment (11),
wherein the presence or imminence of a conversation situation is detected on the basis of movement information and/or location position information of the vehicle (1),
**characterized in that**, in order to detect the presence or imminence of a conversation situation, activities of a vehicle occupant (45, 48) are additionally sensed and evaluated, wherein the positions of the hands of the vehicle driver (45) or of further vehicle occupants (48) are determined or sensed by means of a passenger compartment video monitoring system (4).

2. Method according to Claim 1, **characterized in that** when the vehicle speed is reduced and the vehicle position approaches an edge of the roadway, the presence or imminence of a conversation situation is detected.

3. Method according to one of the preceding claims, **characterized in that** when a vehicle position approaches an infrastructure device at which an acoustic, in particular verbal, communication is taking place between an infrastructure device or personnel of the infrastructure device, on the one hand, and the vehicle driver or a vehicle occupant, on the other, the presence or imminence of a conversation situation is detected.

4. Method according to Claim 3, **characterized in that** the activation of a window lifter for opening a vehicle window (47) is evaluated as confirmation of the presence or imminence of a conversation situation.

5. Method according to one of Claims 3 and 4, **characterized in that** a viewing orientation or head orientation (46) of a vehicle occupant (45) is sensed, and a viewing orientation or head orientation in the direction of the vehicle side window (47) is evaluated as confirmation of the presence or imminence of a conversation situation.

6. Control device (100) for automatically controlling a device (7, 8, 9, 10), specifically a ventilation system or vehicle air-conditioning system, which generates noise (71) in the passenger compartment (11) of a vehicle (1), with detection means (100) for detecting a conversation situation in the vehicle passenger compartment (11), designed to generate a control signal (107, 108, 109, 110) for actuating the device (7, 8, 9, 10) in order to reduce the noise (71) generated by said device (7, 8, 9, 10), in the vehicle passenger compartment (11) in accordance with the detection of a conversation situation in the vehicle passenger compartment (11) by means of the detection means (100),
wherein the detection means (100) are designed to detect the presence or imminence of a conversation situation on the basis of movement information and/or location position information of the vehicle (1),
**characterized by**
a design of a passenger compartment video monitoring system (4) for detecting the presence or imminence of a conversation situation on the basis of activities of a vehicle occupant (45, 48), wherein
positions of the hands of the vehicle driver (45) or of further vehicle occupants (48) are determined or sensed.

7. Control device according to Claim 6, designed to carry out the method according to at least one of Claims 2 to 5.

## Revendications

1. Procédé de commande automatique d'un dispositif (7, 8, 9, 10), à savoir d'un système de ventilation ou de climatisation de véhicule, qui produit des bruits (71) dans l'habitacle (11) d'un véhicule (1), le dispositif (7, 8, 9, 10) étant commandé en vue de réduire les bruits (71) qu'il produit dans l'habitacle (11) du véhicule en fonction de la reconnaissance d'une situation de conversation dans l'habitacle (11) du véhicule,
la présence ou l'imminence d'une situation de conversation étant reconnue sur la base d'une information de mouvement et/ou de position locale du véhicule (1),
**caractérisé en ce**
**qu'**en vue de reconnaître la présence ou l'imminence d'une situation de conversation, des activités d'un occupant du véhicule (45, 48) sont en outre détectées et évaluées,
les positions des mains du conducteur du véhicule (45) ou d'autres occupants du véhicule (48) étant constatées ou détectées au moyen d'une vidéosurveillance de l'habitacle (4).

2. Procédé selon la revendication 1, **caractérisé en ce que** la présence ou l'imminence d'une situation de conversation est reconnue lors de la réduction d'une vitesse du véhicule et de l'approche d'une position du véhicule vers un bord de la chaussée.

3. Procédé selon l'une des revendications précédentes, **caractérisé en ce que** la présence ou l'imminence d'une situation de conversation est reconnue lors de l'approche d'une position du véhicule vers un dispositif d'infrastructure au niveau duquel a lieu une communication sonore, notamment verbale, entre le dispositif d'infrastructure ou le personnel du dispositif d'infrastructure d'une part et le conducteur du véhicule ou un occupant du véhicule d'autre part.

4. Procédé selon la revendication 3, **caractérisé en ce que** l'actionnement d'un lève-vitre en vue d'ouvrir une vitre (47) du véhicule est interprété comme une confirmation de la présence ou de l'imminence d'une situation de conversation.

5. Procédé selon l'une des revendications 3 et 4, **caractérisé en ce qu'**une orientation du regard ou de la tête (46) d'un occupant du véhicule (45) est détectée et une orientation du regard ou de la tête en direction de la fenêtre latérale (47) du véhicule est interprétée comme une confirmation de la présence ou de l'imminence d'une situation de conversation.

6. Dispositif de commande (100) destiné à la commande automatique d'un dispositif (7, 8, 9, 10), à savoir d'un système de ventilation ou de climatisation de véhicule, lequel produit des bruits (71) dans l'habitacle (11) d'un véhicule (1), comprenant des moyens de reconnaissance (100) destinés à reconnaître une situation de conversation dans l'habitacle (11) du véhicule, configuré pour générer un signal de commande (107, 108, 109, 110) en vue de commander le dispositif (7, 8, 9, 10) en vue de réduire les bruits (71) qu'il produit dans l'habitacle (11) du véhicule en fonction de la reconnaissance d'une situation de conversation dans l'habitacle (11) du véhicule par le biais des moyens de reconnaissance (100),
les moyens de reconnaissance (100) étant configurés pour reconnaître la présence ou l'imminence d'une situation de conversation sur la base d'une information de mouvement et/ou de position locale du véhicule (1),
**caractérisé par**
une configuration d'une vidéosurveillance de l'habitacle (4) destinée à reconnaître la présence ou l'imminence d'une situation de conversation sur la base d'activités d'un occupant du véhicule (45, 48), les positions des mains du conducteur du véhicule (45) ou d'autres occupants du véhicule (48) étant constatées ou détectées.

7. Dispositif de commande selon la revendication 6, perfectionné pour mettre en œuvre le procédé selon au moins l'une des revendications 2 à 5.
